(19) Europäisches Patentamt
European Patent Office
Office européen des brevets

(11) **EP 0 938 748 B1**

(12) **EUROPÄISCHE PATENTSCHRIFT**

(45) Veröffentlichungstag und Bekanntmachung des Hinweises auf die Patenterteilung:
**06.03.2002 Patentblatt 2002/10**

(21) Anmeldenummer: **97938774.3**

(22) Anmeldetag: **14.08.1997**

(51) Int Cl.⁷: **H01L 23/48**, H01L 23/495

(86) Internationale Anmeldenummer:
**PCT/DE97/01754**

(87) Internationale Veröffentlichungsnummer:
**WO 98/12745 (26.03.1998 Gazette 1998/12)**

(54) **STROMANSCHLUSS FÜR LEISTUNGSHALBLEITERBAUELEMENT**

POWER CONNECTION FOR POWER SEMICONDUCTOR COMPONENT

CONNEXION ELECTRIQUE POUR COMPOSANT A SEMI-CONDUCTEUR DE PUISSANCE

(84) Benannte Vertragsstaaten:
**FR GB IE IT**

(30) Priorität: **18.09.1996 DE 19638090**

(43) Veröffentlichungstag der Anmeldung:
**01.09.1999 Patentblatt 1999/35**

(73) Patentinhaber: **Infineon Technologies AG**
**81669 München (DE)**

(72) Erfinder: **SCHWARZBAUER, Herbert**
**D-81373 München (DE)**

(74) Vertreter:
**Patentanwälte Westphal, Mussgnug & Partner**
**Waldstrasse 33**
**78048 Villingen-Schwenningen (DE)**

(56) Entgegenhaltungen:
**EP-A- 0 155 473       BE-A- 513 934**
**DE-A- 2 811 933       DE-A- 3 528 427**
**GB-A- 2 135 824       US-A- 3 519 896**

• **PATENT ABSTRACTS OF JAPAN vol. 018, no. 120 (E-1516), 25.Februar 1994 & JP 05 315490 A (FUJI ELECTRIC CO LTD), 26.November 1993,**
• **PATENT ABSTRACTS OF JAPAN vol. 017, no. 150 (E-1339), 25.März 1993 & JP 04 316358 A (MITSUBISHI ELECTRIC CORP), 6.November 1992,**

**Beschreibung**

Die Erfindung betrifft einen Stromanschluß für ein Leistungshalbleiterbauelement nach dem Oberbegriff des Patentanspruchs 1.

In US 3,519,896 ist beispielsweise ein verlötungsfreier Stromanschluß für ein Leistungshalbleiterbauelement durch Metallclips offenbart. EP 0 155 473 beschreibt die Verwendung fest verlöteter Kontaktbügel zur Kontaktierung von Leistungshalbleitermodulen.

In Leistungshalbleiterbauelementen ist oft eine Stromzuführung zu einem Halbleiterkörper durch eine auf einem Keramiksubstrat aufgetragene Kupferschicht gebildet. Über die Kupferschicht wird auch die im Halbleiterkörper im Betrieb des Leistungshalbleiterbauelements erzeugte Wärme abgeführt. Bedingt durch diese einseitige Wärmeabfuhr bzw. Kühlung und den Temperaturabfall an dem Wärme nur schlecht leitenden Keramiksubstrat erreichen Leistungshalbleiterbauelemente bereits in wenigen Sekunden ihre Betriebstemperatur. Dies gilt insbesondere dann, wenn diese modulweise zur Anwendung gelangen, wobei beispielsweise mehrere Leistungshalbleiterbauelemente nebeneinander angeordnet sind.

Das rasche Erreichen der Betriebstemperatur bedingt, daß die Leistungshalbleiterbauelemente bei zahlreichen Anwendungen hohen Lastwechselzahlen, also einer großen Anzahl von Erwärmungs- und Abkühlungsprozessen ausgesetzt sind. So können Lastwechselzahlen erreicht werden, die über $10^5$/Jahr liegen. Jeder Erwärmungs- und Abkühlungsprozeß, d.h. jeder Lastwechsel, ruft thermomechanische Spannungen im Leistungshalbleiterbauelement und dessen Stromzuleitungen hervor. Die hohen Lastwechselzahlen können daher starke Zerstörungen in den Stromzuleitungen auf dem Halbleiterkörper verursachen.

Da die durch hohe Lastwechselzahlen verursachte Materialermüdung um so geringer ist, je stärker das Material der Stromzuführungen in seinem Wärmeausdehnungskoeffizienten an die Wärmeausdehnungskoeffizienten des Halbleiterkörpers, also den Wärmeausdehnungskoeffizienten von Silizium, und des Keramiksubstrats angepaßt ist, wird für das Material der Stromzuführungen oft Molybdän oder auch kupferplattiertes Invar verwendet, welches jeweils auf den Halbleiterkörper bzw. das Keramiksubstrat aufgelötet wird. Die Verwendung solcher Materialien ist beispielsweise aus EP 0 432 867 bekannt. Es hat sich aber gezeigt, daß stets eine wenn auch kleine Fehlanpassung in den Wärmeausdehnungskoeffizienten der verschiedenen Materialien verbleibt und überdies mechanische Spannungen infolge ungleichmäßiger Erwärmung von Lötanschlüssen einerseits und speziell bei Modulbauweise des Modulbodens andererseits hervorgerufen werden. Diese Fehlanpassung führt zusammen mit den mechanischen Spannungen zu einer langsamen Ermüdung der jeweiligen Lötverbindungen zwischen Halbleiterkörper bzw. Keramiksubstrat und Stromzuführungen.

Es ist daher eine **Aufgabe** der vorliegenden Erfindung, einen Stromanschluß für ein Leistungshalbleiterbauelement zu schaffen, der auch bei hohen Lastwechselzahlen praktisch keine Materialermüdung insbesondere an den Lötverbindungen zeigt.

Diese Aufgabe wird bei einem Stromanschluß nach dem Oberbegriff des Patentanspruchs 1 erfindungsgemäß durch die in dessen kennzeichnendem Teil enthaltenen Merkmale gelöst.

Vorteilhafte Weiterbildungen der Erfindung ergeben sich aus den Unteransprüchen.

Bei dem erfindungsgemäßen Stromanschluß sind der aufgelötete Kontaktclip und der Halbleiterkörper des eigentlichen Leistungshalbleiterbauelementes thermisch und mechanisch entkoppelt. Die Lötung der Stromzuführung erfolgt nicht mehr ganzflächig auf der Oberfläche des Halbleiterkörpers, sondern mit Hilfe der mindestens einen Lötöse gegebenenfalls an einigen wenigen kleinflächigen Lötpunkten durch die in der jeweiligen Lötöse eingebrachten Lötkugeln. Die Verbindung zwischen Lötpunkt und eigentlichem Kontaktclip, nämlich die Stromzuführung zum Lötpunkt, ist beispielsweise mäanderförmig gestaltet und besteht aus einem dünnen flexiblen Beinchen oder Bändchen, das zusammen mit der Lötöse aus dem Blech des Kontaktclips gestanzt und in eine näher zur Oberfläche des Halbleiterkörpers gelegenen Ebene nach unten gebogen ist. Länge und Querschnitt dieser Stromzuführung aus dem Beinchen oder Bändchen sind so gewählt, daß die Verlustleistung klein bleibt und auch nur eine geringe Wärmeabführung zwischen Halbleiterkörper und dem Kontaktclip durch die Stromzuführung auftritt. Die elektrische Leitfähigkeit und vor allem die Wärmeleitfähigkeit des eigentlichen Kontaktclips, der einen Anschlußbügel für die Stromzuführung über die Lötöse bildet, werden dagegen so groß eingestellt, daß sich der Anschlußbügel nur wenig über die Temperatur einer Bodenplatte aus einem Keramiksubstrat und einer Kupferschicht, auf der der Halbleiterkörper aufgebracht ist, erwärmt. Dabei soll zwischen der Temperatur $T_1$ des Keramiksubstrats, der Temperatur $T_3$ des Kontaktclips und der Temperatur $T_2$ des Halbleiterkörpers die folgende Beziehung gelten:

$$T_2 \gg T_3 > T_1.$$

Auf diese Weise entstehen auch bei großen Temperaturschwankungen nur äußerst geringe thermomechanische Spannungen zwischen der Stromzuführung bzw. dem Kontaktclip und dem Halbleiterkörper bzw. dem eigentlichen Leistungshalbleiterbauelement. Durch eine zusätzliche Unterfüllung des Raumes bzw. Spaltes zwischen dem Halbleiterkörper und dem Kontaktclip mit einem im Wärmeausdehnungskoeffizienten an die Wärmeausdehnungskoeffizienten des Kontaktclips bzw. des Halbleiterkörpers angepaßten Material, vorzugsweise einem Kleber, kann jede Relativbewegung elastisch ohne Verformung und Ermüdung der Lötpunkte aufgenommen werden. Der Kontaktclip bzw. die mäanderförmige Stromzuführung sind aus einem Trimetallblech mit "symmetrischer" Schichtenfolge hergestellt. Geeignete Schichten sind beispielsweise Kupfer-Invar-Kupfer. Jedoch kann anstelle dieser Schichten auch ein Molybdänblech verwendet werden. Die Lötösen, in die später die Lötkugeln eingebracht werden, und die Stromzuführung zu diesen können aus einem solchen Blech durch Freiätzen oder einen Laserschnitt ausgeformt werden.

Nachfolgend wird die Erfindung anhand einer Zeichnung näher erläutert. Es zeigen:

Fig. 1    eine Draufsicht auf einen Kontaktclip;

Fig. 2    den Kontaktclip von Fig. 1 im Schnitt A-A, wenn
er auf ein Leistungshalbleiterbauelement aufgebracht ist, im Schnitt;

Fig. 3    eine Unterfüllung für den Kontaktclip im Schnitt und

Fig. 4    eine Schichtenfolge für den Kontaktclip.

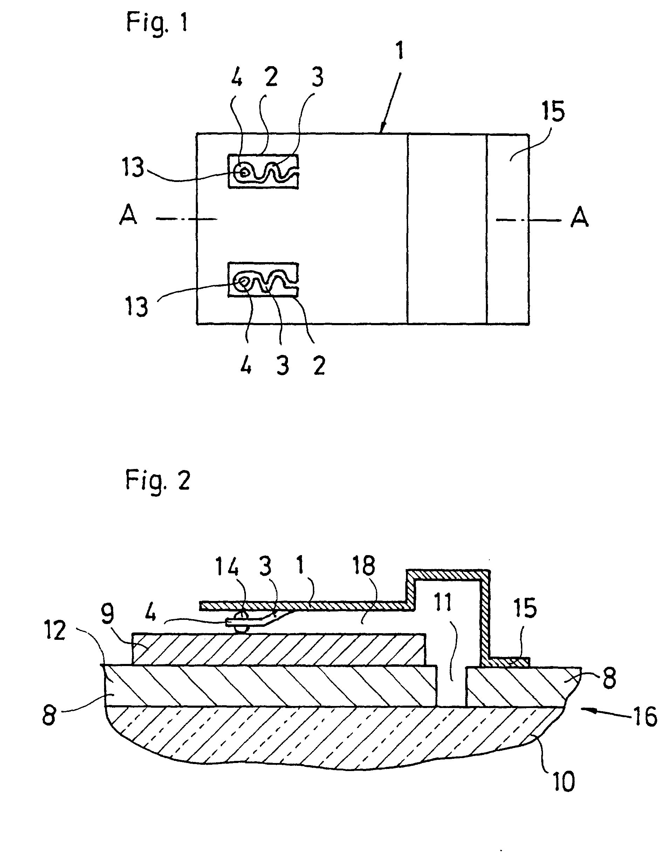

Fig. 1 zeigt einen Kontaktclip 1, aus dem in Bereichen 2 Stromzuführungen 3 zu Lötösen 4 durch Freiätzen oder Laserschnitt ausgeformt sind.

Wie aus Fig. 2 zu ersehen ist, liegen die Stromzuführung 3 und die Lötöse 3 "unterhalb" der Ebene des eigentlichen Kontaktclips 1, was durch einen entsprechenden Biegevorgang nach dem Freiätzen bzw. dem Laserschnitt erreicht werden kann.

Der eigentliche Kontaktclip 1, der einen Anschlußbügel für die Stromzuführung 3 darstellt, diese Stromzuführung 3 und die Lötöse 4 sind materialeinheitlich hergestellt und bestehen beispielsweise aus Molybdän oder aus einem Trimetallblech mit symmetrischer Schichtenfolge, um einen Bimetalleffekt mit einseitigen Verbiegungen zu vermeiden. Fig, 4 zeigt eine solche mögliche Schichtenfolge mit einer Kupferschicht 5, einer Invarschicht 6 und einer weiteren Kupferschicht 7. Invar wird gewählt, da es einen besonders niedrigen Wärmeausdehnungskoeffizienten hat.

Der Kontaktclip 1 ist, wie Fig. 2 zeigt, zwischen einer Kupferschicht 8 und einem Halbleiterkörper 9 geführt. Die Kupferschicht 8 ist beispielsweise durch DCB-Technik (DCB = "Direkt-Kupfer-Bonden") auf ein Keramiksubstrat 10 aus vorzugsweise Aluminiumoxid aufgebracht und durch einen Spalt 11 unterbrochen, so daß der "linke" Teil der Kupferschicht 8 eine Elektrode 12 für den Halbleiterkörper 9 bildet. Der Spalt 11 kann beispielsweise durch Ätzen hergestellt werden, nachdem die Kupferschicht 8 auf das Keramiksubstrat 10 aufgebracht wurde.

Im Ausführungsbeispiel der Fig. 1 und 2 sind zwei Bereiche 2 mit jeweils einer Lötöse 4 vorgesehen.

In die Öffnung 13 jeder Lötöse 4 wird eine Lötkugel 14 zur Kontaktgabe mit dem Halbleiterkörper 9 eingebracht, so daß hier zwei kleinflächige Lötpunkte vorliegen.

Die Stromzuführung 3 ist zur Zugentlastung mäanderförmig gestaltet und bildet ein dünnes flexibles Beinchen oder Bändchen, das in Länge und Querschnitt so ausgeführt ist, daß Verlustleistung und Wärmeabführung vom Halbleiterkörper 9 zum Kontaktclip 1 gering bleiben.

An seinem vom Halbleiterkörper 9 abgewandten Ende 15 ist der Kontaktclip 1 mit der durch den Spalt 11 von der Elektrode 12 getrennten Kupferschicht 8 verbunden, wobei der Kontaktclip 1 zur weiteren Zugentlastung U-förmig gebogen sein kann.

Das Keramiksubstrat 10 und die Kupferschicht 8 bilden eine Bodenplatte 16 für den Halbleiterkörper 9 und den Kontaktclip 1, also für das eigentliche Leistungshalbleiterbauelement. Die elektrische Leitfähigkeit und vor allem die Wärmeleitfähigkeit des Kontaktclips 1 zur Kupferschicht 8 bzw. zur Bodenplatte 16 werden so groß gewählt, daß sich der Kontaktclip 1 nur wenig über die Bodenplattentemperatur erwärmt und zwischen der Temperatur $T_1$ der Bodenplatte 16 bzw. der Kupferschicht 8 (im Bereich außerhalb der Elektrode 12), der Temperatur $T_3$ des Kontaktclips 1 und der Temperatur $T_2$ des Halbleiterkörpers die folgende Beziehung gilt.

$$T_2 \gg T_3 > T_1$$

Wie bereits oben erwähnt wurde, sind im vorliegenden Ausführungsbeispiel zwei Lötpunkte vorgesehen. Jedoch können auch mehr als zwei Lötpunkte und damit Bereiche 2 mit Stromzuführungen 3 und Lötösen 4 zur Anwendung gelangen. In Sonderfällen ist auch nur ein Lötpunkt ausreichend, wenn die Verlustleistung in der einen Stromzuführung ausreichend niedrig bleibt.

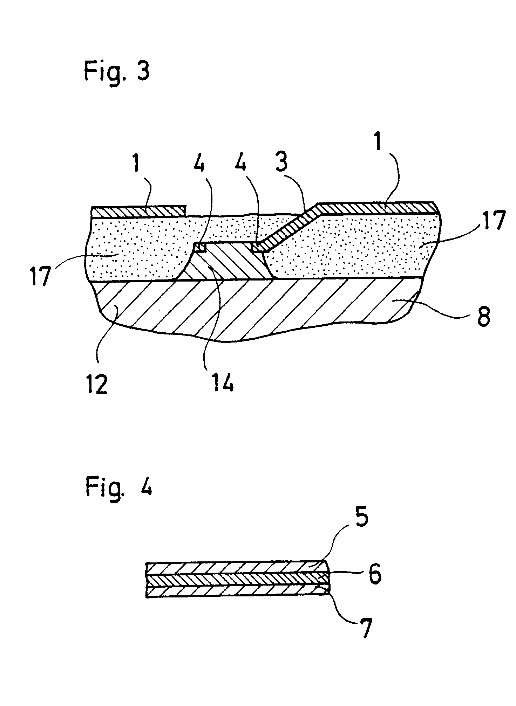

Wie Fig. 3 zeigt, kann in den Raum 18 zwischen dem Kontaktclip 1 und dem Halbleiterkörper 9 eine Unterfüllung 17 eingebracht werden. Diese Unterfüllung 17 besteht aus einem Kleber, der in seinem Wärmeausdehnungskoeffizienten an die Wärmeausdehnungskoeffizienten des Halbleiterkörpers 9 bzw. des Kontaktclips 1 angepaßt ist. Ein geeigneter Kleber ist beispielsweise ein üblicher Flip-Chip-Underfiller. Damit kann jede Relativbewegung elastisch ohne Verformung und Ermüdung der Lötpunkte aufgenommen werden.

Die Erfindung schafft so einen Stromanschluß für ein Leistungshalbleiterbauelement, der auch bei hohen Lastwechselzahlen praktisch keine Materialermüdung insbesondere an den Lötpunkten bzw. Lötverbindungen zeigt.

**Patentansprüche**

1. Stromanschluß für ein Leistungshalbleiterbauelement, der innerhalb eines Bodenplattenbereichs (16) ausgebildet ist, mit einem auf der Bodenplatte montierten Halbleiterkörper (9), einem Kontaktclip (1) und einer den Halbleiterkörper (9) mit dem Kontaktclip (1) verbindenden Lötverbindung,,
**dadurch gekennzeichnet,**
**daß** die Lötverbindung zwischen dem Halbleiterkörper (9) und dem Kontaktclip (1) als kleinflächiger Lötpunkt ausgebildet ist und
**daß** der Kontaktclip (1) mindestens eine zugentlastete Lötöse (4) aufweist, in der der kleinflächige Lötpunkt zum Halbleiterkörper (9) gebildet ist, so daß der Kontaktclip (1) und der Halbleiterkörper (9) thermisch und mechanisch entkoppelt sind.

2. Stromanschluß nach Anspruch 1,
**dadurch gekennzeichnet,**
**daß** die zugentlastende Lötöse (4) eine mäanderförmige Stromzuführung (3) aufweist.

3. Stromanschluß nach Anspruch 2,
**dadurch gekennzeichnet,**
**daß** die Stromzuführung (3) und die Lötöse (4) materialeinheitlich mit dem Kontaktclip (1) ausgeführt sind.

4. Stromanschluß nach Anspruch 3,
**dadurch gekennzeichnet,**
**daß** die Stromzuführung (3) und die Lötöse (4) in eine näher zum Halbleiterkörper (9) als das von Halbleiterkörper abgewandten Ende (15) des Kontaktclips (1) gelegenen Ebene gebildet sind.

5. Stromanschluß nach einem der Ansprüche 1 bis 4,
**dadurch gekennzeichnet,**
**daß** der Kontaktclip (1) aus einem Trimetallblech (5, 6, 7) oder aus Molybdän gebildet ist.

6. Stromanschluß nach Anspruch 5,
**dadurch gekennzeichnet,**
**daß** das Trimetallblech eine Schichtenfolge aus Materialien A-B-A aufweist.

7. Stromanschluß nach Anspruch 6,
**dadurch gekennzeichnet,**
**daß** das Material A durch Kupfer und das Material B durch Invar gebildet sind.

8. Stromanschluß nach einem der Ansprüche 1 bis 7,
**dadurch gekennzeichnet,**
**daß** zwischen Kontaktclip (1) und Halbleiterkörper (9) eine Unterfüllung (17) vorgesehen ist.

9. Stromanschluß nach Anspruch 8,
**dadurch gekennzeichnet,**
**daß** die Unterfüllung (17) aus einem Kleber besteht, dessen Wärmeausdehnungskoeffizient an diejenigen von Kontaktclip (1) und Halbleiterkörper (9) angepaßt ist.

10. Stromanschluß nach einem der Ansprüche 1 bis 9,
**dadurch gekennzeichnet,**
**daß** der Halbleiterkörper (9) auf einer auf einem Keramiksubstrat (10) liegenden Kupferschicht (8) vorgesehen ist.

11. Stromanschluß nach Anspruch 10,
**dadurch gekennzeichnet,**
**daß** der Kontaktclip (1) an seinem vom Halbleiterkörper (9) abgewandten Ende (15) großflächig mit der Kupferschicht (8) bzw. dem Keramiksubstrat (10) verbunden ist, so daß er sich nur wenig über die Temperatur der Kupferschicht (8) erwärmt.

12. Stromanschluß nach Anspruch 11,
**dadurch gekennzeichnet,**
**daß** für die Temperatur $T_1$ des Keramiksubstrats (10), die Temperatur $T_3$ des Kontaktclips (1) und die Temperatur $T_2$ des Halbleiterkörpers (9) im Betrieb des Leistungshalbleiterbauelements gilt:

$$T_2 \gg T_3 > T_1.$$

**Claims**

1. A power connection for a power semiconductor component which is constructed inside a base plate area (16), with a semiconductor body (9) mounted on the base plate, a contact clip (1) and a soldered joint connecting the semiconductor body (9) with the contact clip (1),
**characterised in that** the soldered joint is constructed between the semiconductor body (9) and the contact clip (1) as a soldering point having a small area
**and in that** the contact clip (1) comprises at least one strain-relieved soldering eyelet (4), in which the soldering point, having a small area, to the semiconductor body (9) is formed so that the contact clip (1) and the semiconductor body (9) are thermally and mechanically decoupled.

2. A power connection according to Claim 1,
**characterised in that** the strain-relieved soldering eyelet (4) comprises a meandring voltage feed (3).

3. A power connection according to Claim 2,
**characterised in that** the voltage feed (3) and the soldering eyelet (4) are designed from the same material as the contact clip (1).

**4.** A power connection according to Claim 3, **characterised in that** the voltage feed (3) and the soldering eyelet (4) are formed in a plane positioned closer to the semiconductor body (9) than the end (15) of the contact clip (1) remote from the semiconductor body.

**5.** A power connection according to one of Claims 1 to 4, **characterised in that** the contact clip (1) is made from a trimetal sheet (5, 6, 7) or from molybdenum.

**6.** A power connection according to Claim 5, **characterised in that** the trimetal sheet comprises a sequence of layers consisting of materials A-B-A.

**7.** A power connection according to Claim 6, **characterised in that** material A is made of copper and material B is made of invar.

**8.** A power connection according to one of Claims 1 to 7, **characterised in that** an underfilling (17) is provided between contact clip (1) and semiconductor body (9).

**9.** A power connection according to Claim 8, **characterised in that** the underfilling (17) consists of a bonding agent, the thermal expansion coefficient of which is adapted to those of the contact clip (1) and semiconductor body (9).

**10.** A power connection according to one of Claims 1 to 9, **characterised in that** the semiconductor body (9) is provided on a copper layer (8) lying on a ceramic substrate (10).

**11.** A power connection according to Claim 10, **characterised in that** the contact clip (1) is connected at its end (15) remote from the semiconductor body (9) with the copper layer (8) or the ceramic substrate (10) over a large area so that it is only heated to slightly above the temperature of the copper layer (8).

**12.** A power connection according to Claim 11, **characterised in that** for the temperature $T_1$ of the ceramic substrate (10), the temperature $T_3$ of the contact clip (1) and the temperature $T_2$ of the semiconductor body (9) in the operation of the power semiconductor component the following applies:

$$T_2 \gg T_3 > T_1.$$

**Revendications**

**1.** Connexion électrique d'un composant semi-conducteur de puissance réalisée dans une zone de plaque de fond (16) ayant un corps semi-conducteur (9) monté sur la plaque de fond, un clip de contact (1) et une liaison soudée reliant le corps semi-conducteur (9) au clip de contact (1), **caractérisée en ce que** la liaison soudée entre le corps semi-conducteur (9) et le clip de contact (1) est réalisée sous la forme d'un point de soudure de petite surface et le clip de contact (1) présente au moins un oeillet de soudage (4) déchargé en traction, au niveau duquel est réalisé le point de soudure de petite surface avec le corps semi-conducteur (9) pour que le clip de contact (1) et le corps semi-conducteur (9) soient découplés thermiquement et mécaniquement.

**2.** Connexion électrique selon la revendication 1, **caractérisée en ce que** l'oeillet de soudure (4) déchargé en traction comporte une liaison électrique (3) en forme de méandres.

**3.** Connexion électrique selon la revendication 2, **caractérisée en ce que** la liaison électrique (3) et l'oeillet de soudure (4) sont réalisés dans la même matière que le clip de contact (1).

**4.** Connexion électrique selon la revendication 3, **caractérisée en ce que** l'alimentation électrique (3) et l'oeillet de soudure (4) sont formés dans un plan situé plus près du corps semi-conducteur (9) que l'extrémité (15) du clip de contact (1), à l'opposé du corps semi-conducteur.

**5.** Connexion électrique selon l'une quelconque des revendication 1 à 4, **caractérisée en ce que** le clip de contact (1) est formé d'une tôle en trimétal (5, 6, 7) ou en molybdène.

**6.** Connexion électrique selon la revendication 5, **caractérisée en ce que** la tôle de trimétal a une succession de couches de matière (A-B-A).

**7.** Connexion selon la revendication 6, **caractérisée en ce que** la matière (A) est du cuivre et la matière (B) de l'invar.

**8.** Connexion électrique selon l'une quelconque des revendication 1 à 7, **caractérisée par**

un remplissage (17) inférieur entre le clip de contact (1) et le corps semi-conducteur (9).

9. Connexion selon la revendication 8,
   **caractérisée en ce que**
   le remplissage (17) est formé d'une colle dont le coefficient de dilatation thermique est adapté à celui du clip de contact (1) et du corps semi-conducteur (9).

10. Connexion électrique selon l'une quelconque des revendication 1 à 9,
    **caractérisée en ce que**
    le corps semi-conducteur (9) est prévu sur une couche de cuivre (8) située sur un substrat en céramique (10).

11. Connexion selon la revendication 10,
    **caractérisée en ce que**
    le clip de contact (1) est relié par son extrémité (15), à l'opposé du corps semi-conducteur (9), à une couche de cuivre (8) ou au substrat en céramique (10) pour qu'il ne se chauffe que très peu au-dessus de la température de la couche de cuivre (8).

12. Connexion selon la revendication 11,
    **caractérisée en ce que**
    pour la température ($T_1$) du substrat en céramique (10), la température ($T_3$) du clip de contact (1) et la température ($T_2$) du corps semi-conducteur (9), en fonctionnement du composant semi-conducteur de puissance on a la relation :

$$T_2 \gg T_3 > T_1.$$

Fig. 1

Fig. 2

Fig. 3

Fig. 4